# EUROPÄISCHE PATENTSCHRIFT

(11) **EP 4 045 448 B1**
(45) Veröffentlichungstag und Bekanntmachung des Hinweises auf die Patenterteilung: **07.08.2024**
(21) Anmeldenummer: 20789167.2
(22) Anmeldetag: 14.10.2020
(51) Int. Cl.: B66B 5/00, B66B 19/00

(54) **VERFAHREN UND VORRICHTUNG ZUM DURCHFÜHREN EINER ZUMINDEST TEILVIRTUALISIERTEN KONFORMITÄTSBEWERTUNG BEI EINER PERSONENTRANSPORTANLAGE UNTER VERWENDUNG EINES DIGITALER-DOPPELGÄNGER-DATENSATZES**
METHOD AND DEVICE FOR CARRYING OUT AN AT LEAST PARTIALLY VIRTUALISED ACCEPTANCE INSPECTION IN A PERSONAL TRANSPORT SYSTEM USING A DIGITAL TWIN
PROCÉDÉ ET DISPOSITIF POUR EFFECTUER UNE INSPECTION D'ACCEPTATION AU MOINS PARTIELLEMENT VIRTUALISÉE DANS UN SYSTÈME DE TRANSPORT PERSONNEL À L'AIDE D'UN JUMEAU NUMÉRIQUE

(30) Priorität: 18.10.2019 EP 19203976
(43) Veröffentlichungstag der Anmeldung: 24.08.2022
(73) Patentinhaber: INVENTIO AG, 6052 Hergiswil (CH)
(72) Erfinder: CORTONA, Elena, 8002 Zürich (CH)
(74) Vertreter: Inventio AG
(86) Internationale Anmeldenummer: PCT/EP2020/078895
(87) Internationale Veröffentlichungsnummer: WO 2021/074220

(56) Entgegenhaltungen:
- WO-A1-2019/115378
- WO-A1-2019/115380
- US-A1- 2015 154 324

## Beschreibung

Die vorliegende Erfindung betrifft ein Verfahren und eine Vorrichtung zum Durchführen einer Konformitätsbewertung an einer Personentransportanlage wie zum Beispiel einem Aufzug, einer Fahrtreppe oder einem Fahrsteig. Ferner betrifft die Erfindung ein zur Durchführung des vorgeschlagenen Verfahrens ausgebildetes Computerprogrammprodukt sowie ein dieses Computerprogrammprodukt speicherndes computerlesbares Medium.

Personentransportanlagen in Form von Aufzügen, Fahrtreppen oder Fahrsteigen dienen dazu, Personen innerhalb von Gebäuden oder Bauwerken zu befördern.

Neu zu bauende Personentransportanlagen werden im Allgemeinen zunächst während einer Planungsphase konzipiert. Dabei werden für jede einer Vielzahl von Komponenten, aus denen die Personentransportanlage zusammengesetzt ist, physikalische Eigenschaften vorgegeben. Beispielsweise können für eine Komponente eine spezifische Geometrie, spezifische Dimensionen, spezifische Materialien, spezifische Materialeigenschaften, spezifische Funktionalitäten und/oder Ähnliches als konzeptionsspezifische Soll-Eigenschaften vorgegeben werden. Die gesamte Personentransportanlage einschließlich deren Komponenten können auf diese Weise individualisiert für einen spezifischen Einsatzzweck konzipiert werden. Der Einsatzzweck kann hierbei beispielsweise durch Rahmenbedingungen an einem Einsatzort für die Personentransportanlage, Anforderungen an Funktionalitäten der Personentransportanlage, vom Nutzer gewünschte oder durch Regularien vorgegebene Eigenschaften der Personentransportanlage, etc. charakterisiert sein. Die WO 2019 / 115380 A1 offenbart ein Verfahren zur Herstellung einer Personentransportanlage der vorgenannten Art, unter Verwendung eines digitalen Doppelgängers.

Nachdem die Personentransportanlage für ihren spezifischen Einsatzzweck konzipiert wurde, können die einzelnen Komponenten gefertigt werden. Dabei sollten bei der Fertigung realisierte Ist-Eigenschaften einer Komponente innerhalb einer akzeptablen Toleranz möglichst genau den konzeptionsspezifischen Soll-Eigenschaften der Komponente entsprechen.

Anschließend werden die gefertigten Komponenten an den Einsatzort, an dem die Personentransportanlage installiert werden soll, gebracht und die Personentransportanlage dort durch Zusammenbauen der Komponenten installiert.

Vor einer Inbetriebnahme der Personentransportanlage bzw. einer Übergabe der Personentransportanlage an einen Nutzer wird regelmäßig eine sogenannte Konformitätsbewertung durchgeführt. Bei dieser Konformitätsbewertung wird überprüft, dass die letztendlich fertig installierte Personentransportanlage vorgegebenen Anforderungen entspricht und/oder in einer gewünschten Weise funktioniert.

Die Durchführung der Konformitätsbewertung ist regelmäßig recht zeitaufwändig. Außerdem erfordert sie speziell geschultes Personal. Letztendlich werden durch die Konformitätsbewertung erhebliche Kosten generiert.

Wenn sich im Rahmen der Konformitätsbewertung herausstellt, dass die Personentransportanlage bestimmten Anforderungen nicht gerecht wird oder bestimmte Funktionalitäten nicht in gewünschter Weise implementiert sind, müssen eventuell geeignete Maßnahmen eingeleitet werden. Beispielsweise müssen bereits gefertigte Komponenten modifiziert werden oder geänderte Komponenten neu gefertigt werden. Gegebenenfalls müssen die modifizierten oder neu gefertigten Komponenten an den Einsatzort gebracht und dort installiert werden. Hierdurch können ein erheblicher zusätzlicher Arbeitsaufwand und/oder zusätzliche Kosten entstehen. Außerdem kann es zu einer Verzögerung der Fertigstellung der Personentransportanlage kommen. Diese Verzögerung kann insbesondere zu einem Zeitpunkt eintreten, zu dem ein Kunde bereits auf die Fertigstellung der Personentransportanlage wartet.

Außerdem kann herkömmlich im Rahmen der Konformitätsbewertung lediglich erkannt werden, ob bzw. wie die fertig installierte Personentransportanlage bestimmten Anforderungen nicht gerecht wird bzw. bestimmte Funktionalitäten nicht wie gewünscht implementiert sind. Gründe, weswegen solche Defizite auftreten, können im Regelfall nicht ermittelt werden. Insbesondere kann beispielsweise nicht erkannt werden, ob bereits bei der Konzeption der Personentransportanlage Fehler aufgetreten sind oder ob die Personentransportanlage zwar korrekt konzipiert wurde, aber dann bei der Fertigung der Komponenten Fehler aufgetreten sind oder ob alle Komponenten korrekt konzipiert und gefertigt wurden aber letztendlich fehlerhaft installiert wurden.

Es kann somit unter anderem ein Bedarf an einem Verfahren oder einer Vorrichtung bestehen, mithilfe derer ein Aufwand für eine durchzuführende Konformitätsbewertung verringert werden kann, Risiken, dass bei der Konzeption, Fertigung und/oder Installation von die Personentransportanlage bildenden Komponenten Fehler auftreten, verringert werden können und/oder eine Ursachenanalyse für den Fall, dass dennoch solche Fehler erkannt werden, vereinfacht werden kann. Ferner kann ein Bedarf an einer zur Durchführung eines solchen Verfahrens eingerichteten Vorrichtung, einem Computerprogrammprodukt zum Durchführen des Verfahrens auf einer programmierbaren Vorrichtung sowie einem computerlesbaren Medium mit einem darauf gespeicherten solchen Computerprogrammprodukt bestehen.

Einem solchen Bedarf kann durch den Gegenstand gemäß einem der unabhängigen Ansprüche entsprochen werden. Vorteilhafte Ausführungsformen sind in den abhängigen Ansprüchen sowie der nachfolgenden Beschreibung definiert.

Gemäß einem ersten Aspekt der Erfindung wird ein Verfahren zum Durchführen einer zumindest teilvirtualisierten Konformitätsbewertung an einer Personentransportanlage beschrieben. Die Konformitätsbewertung wird dabei einem vorgegebenen Prüfprotokoll folgend vor Übergabe der Personentransportanlage an einen Nutzer durchgeführt. Die Personentransportanlage wurde vorab individualisiert für einen Einsatzzweck mit einer Vielzahl von Komponenten vollständig konzipiert. Es ist ein die individualisiert konzipierte Personentransportanlage abbildender Digitaler-Doppelgänger-Datensatz erstellt, in welchem physikalische Eigenschaften von Komponenten der Personentransportanlage in maschinen-verarbeitbarer Weise wiedergegeben sind. Bei der Konformitätsbewertung wird geprüft, ob Eigenschaften der Personentransportanlage vordefinierten Soll-Vorgaben entsprechen. Diese Soll-Vorgaben definieren zumindest eine korrekte Funktion der Komponenten und/oder eine korrekte Kooperation der Komponenten untereinander und/oder sicherheitsrelevante Eigenschaften der Personentransportanlage. Dabei werden bei der Durchführung der Konformitätsbewertung zumindest einige der bei der Konformitätsbewertung zu prüfenden Eigenschaften der Personentransportanlage im Rahmen von virtualisierten Konformitätsbewertungsschritten durch Ableiten von Werten aus dem Digitaler-Doppelgänger-Datensatz oder durch Simulationen basierend auf dem Digitaler-Doppelgänger-Datensatz ermittelt und als Virtuell-Werte in einem Ergebnisprotokoll angegeben. Hierbei basieren zumindest einige der bei der Konformitätsbewertung zu prüfenden Eigenschaften der Personentransportanlage auf den physikalischen Eigenschaften der Komponenten.

Gemäß einem zweiten Aspekt der Erfindung wird eine Vorrichtung zum Durchführen einer zumindest teilvirtualisierten Konformitätsbewertung bei einer Personentransportanlage vorgeschlagen, wobei die Vorrichtung dazu konfiguriert ist, ein Verfahren gemäß einer Ausführungsform des ersten Aspekts der Erfindung durchzuführen oder zu steuern.

Gemäß einem dritten Aspekt der Erfindung wird ein Computerprogrammprodukt vorgeschlagen, welches maschinenlesbare Programmanweisungen umfasst, welche bei Ausführung auf einer programmierbaren Vorrichtung die Vorrichtung zum Durchführen oder Steuern eines Verfahrens gemäß einer Ausführungsform des ersten Aspekts der Erfindung veranlassen.

Gemäß einem vierten Aspekt der Erfindung wird ein computerlesbares Medium vorgeschlagen, auf dem ein Computerprogrammprodukt gemäß einer Ausführungsform des dritten Aspekts der Erfindung gespeichert ist.

Mögliche Merkmale und Vorteile von Ausführungsformen der Erfindung können unter anderem und ohne die Erfindung einzuschränken als auf nachfolgend beschriebenen Ideen und Erkenntnissen beruhend angesehen werden.

Im Gegensatz zu manchen anderen Wirtschaftsgütern sind Personentransportanlagen generell nicht in ihrer Gesamtheit standardisierbar, d.h. als standardmäßig konfigurierte Produkte bereitstellbar. Stattdessen wird jede Personentransportanlage individuell für einen Einsatzzweck angepasst konzipiert.

Der Einsatzzweck kann beispielsweise durch vorgegebene Bedingungen an einem Einsatzort, von einem Nutzer gewünschte Funktionalitäten und/oder einzuhaltende Regularien bestimmt bzw. beeinflusst sein. Parameter, die einen solchen Einsatzweck definieren, können dabei beispielsweise Dimensionen der Personentransportanlage, angestrebte Transportkapazitäten, Anordnungen und Eigenschaften von Anbindungsschnittstellen, an denen die Personentransportanlage in ein zu versorgendes Gebäude eingebunden wird, zu implementierende Eigenschaften zum Gewährleisten eines sicheren Betriebs der Personentransportanlage, etc. sein.

Eine Personentransportanlage besteht dabei regelmäßig aus einer Vielzahl von miteinander interagierenden Komponenten. Die Komponenten können beispielsweise statische Komponenten, welche an dem Gebäude fest installiert werden, dynamische Komponenten, die relativ zu dem Gebäude verlagert werden können, Antriebskomponenten, welche die dynamischen Komponenten verlagern können, Steuerungskomponenten, welche die Antriebkomponenten steuern, Überwachungskomponenten, welche Zustände in der Personentransportanlage überwachen, Sicherheitskomponenten, welche einen sicheren Betrieb der Personentransportanlage sicherstellen, und andere Komponenten umfassen.

Während einer Konzeptionsphase bzw. Planung der Personentransportanlage, welche teilweise auch als Kommissionierung bezeichnet wird, werden diese Komponenten derart konzipiert bzw. ausgewählt, dass aus ihnen letztendlich die gesamte Personentransportanlage zusammengesetzt werden kann und die Personentransportanlage dabei die während der Konzeptionsphase festgelegten Eigenschaften und Funktionalitäten erlangt.

Wie einleitend angemerkt, muss regelmäßig vor Aufnahme eines normalen Betriebs einer Personentransportanlage bzw. vor Übergabe der Personentransportanlage an einen Nutzer sichergestellt werden, dass die Personentransportanlage hinsichtlich ihrer physikalischen Eigenschaften und ihrer Funktionalitäten zuvor definierten Vorgaben entspricht.

Herkömmlich wird hierzu nach Abschluss einer Installation die Personentransportanlage einer Konformitätsbewertung unterzogen. Bei der Konformitätsbewertung wird die gesamte Personentransportanlage im Rahmen verschiedener Konformitätsbewertungsschritte auf ihre physikalischen Eigenschaften bzw. Funktionalitäten hin untersucht. Die Konformitätsbewertung folgt dabei regelmäßig einem vorgegebenen Prüfprotokoll. In dem Prüfprotokoll ist beispielsweise eine Sequenz durchzuführender Prüfschritte angegeben, wobei für jeden der Prüfschritte vorgegeben wird, wie dieser Prüfschritt durchzuführen ist bzw. auf welche Randbedingungen bzw. Eigenschaften der Personentransportanlage zu achten ist. Das Prüfprotokoll kann beispielsweise von einem Hersteller der Personentransportanlage vorgegeben werden. Dabei ist das Prüfprotokoll regelmäßig in einer Weise abgefasst, dass bei Durchführung der Prüfschritte in technisch sinnvoller Weise überprüft wird, ob Komponenten der Personentransportanlage beispielsweise korrekt funktionieren, mit anderen Komponenten kooperieren und/oder in geeigneter Weise zu einem sicheren Betrieb der Personentransportanlage beitragen.

Herkömmlich werden alle Prüfschritte der Konformitätsbewertung an der realen Personentransportanlage durchgeführt. Somit muss die Personentransportanlage vor Durchführung der Konformitätsbewertung vollständig installiert worden sein. Dementsprechend kann bei der Konformitätsbewertung lediglich festgestellt werden, ob die fertiggestellte Personentransportanlage den Vorgaben und Anforderungen entspricht. Sollte dies jedoch nicht der Fall sein, kann rückwirkend nicht analysiert werden, weswegen Vorgaben nicht entsprochen wird bzw. Anforderungen nicht erfüllt werden. Um die bereits fertig installierte Personentransportanlage in einem solchen Fall dennoch in Betrieb nehmen zu dürfen, kann es außerdem nötig sein, diese bzw. einige von deren Komponenten nachträglich zu modifizieren oder auszutauschen, womit zusätzlicher Arbeits- und/oder Kostenaufwand einhergehen kann.

Um insbesondere die beschriebenen Nachteile, wie sie bei der herkömmlichen Konformitätsbewertung typischerweise auftreten können, zu vermeiden, wird vorgeschlagen, statt oder eventuell ergänzend zu einer Konformitätsbewertung an der realen, bereits fertig gestellten Personentransportanlage eine zumindest teilvirtualisierte Konformitätsbewertung durchzuführen, bei der ähnlich wie bei der herkömmlichen Konformitätsbewertung geprüft wird, ob Eigenschaften der Personentransportanlage Soll-Vorgaben entsprechen, bei der jedoch im Unterschied zur herkömmlichen Konformitätsbewertung eine solche Überprüfung nicht oder zumindest nicht ausschließlich an der realen, bereits fertig gestellten Personentransportanlage, sondern unter Zuhilfenahme eines Digitaler-Doppelgänger-Datensatzes (nachfolgend teilweise auch kurz als digitaler Doppelgänger bezeichnet) durchgeführt wird.

Dabei können im Rahmen von virtualisierten Konformitätsbewertungsschritten Werte aus dem Digitaler-Doppelgänger-Datensatz abgeleitet oder durch Simulationen basierend auf Informationen, wie sie in dem Digitaler-Doppelgänger-Datensatz enthalten sind, ermittelt werden. Diese Werte können beispielsweise angeben, wie physikalische Eigenschaften und/oder Funktionalitäten der Personentransportanlage ausgestaltet sind. Da diese Werte nicht durch Versuche und/oder Messungen an der realen Personentransportanlage, sondern unter Berücksichtigung des Digitaler-Doppelgänger-Datensatzes, d.h. quasi an einer virtuellen Personentransportanlage, erhalten werden, werden diese hierin auch als Virtuell-Werte bezeichnet. Diese Virtuell-Werte können dann in einem Ergebnisprotokoll angegeben werden. Durch Analyse dieses Ergebnisprotokolls kann schließlich ermittelt werden, ob die mit dem Digitaler-Doppelgänger-Datensatz wiedergegebene Personentransportanlage den gewünschten Soll-Vorgaben entspricht.

Da die vorgeschlagene zumindest teilvirtualisierte Konformitätsbewertung bereits zu einem Zeitpunkt durchgeführt werden kann, in dem die Personentransportanlage noch nicht abschließend installiert ist bzw. sogar zu einem Zeitpunkt, bei dem die Komponenten, aus denen die Personentransportanlage zusammengebaut werden soll, noch nicht fertiggestellt sind, kann mithilfe des hierin vorgeschlagenen Verfahrens bereits zu einem sehr frühen Zeitpunkt erkannt werden, wenn sich bei der Konformitätsbewertung Mängel für die Personentransportanlage offenbaren. Dementsprechend können gegebenenfalls bereits zu diesem frühen Zeitpunkt Gegenmaßnahmen eingeleitet werden. Beispielsweise kann eine Konzeption der Personentransportanlage angepasst werden. Somit können Kosten und Aufwand für eine fehlerhafte bzw. ungeeignete Fertigung von Komponenten und/oder für deren Transport zum Einsatzort und/oder Installation am Einsatzort vermieden werden.

Die beim Erstellen des Digitaler-Doppelgänger-Datensatzes zu berücksichtigenden physikalischen Eigenschaften können beispielsweise geometrische Abmessungen der Komponenten, Gewichte der Komponenten, Materialeigenschaften der Komponenten und/oder Oberflächenbeschaffenheiten der Komponenten sein. Mit anderen Worten können mehrere verschiedenartige physikalische Eigenschaften von einer Komponente oder von mehreren Komponenten einer Personentransportanlage ermittelt oder vordefiniert werden und dann als Daten in dem Digitaler-Doppelgänger-Datensatz abgelegt werden. Geometrische Abmessungen der Komponenten können beispielsweise eine Länge, eine Breite, eine Höhe, ein Querschnitt, Radien, Verrundungen, etc. der Komponenten sein. Materialeigenschaften der Komponenten können beispielsweise eine zur Bildung einer Komponente oder eines Teilbereichs einer Komponente verwendete Materialart sein. Ferner können Materialeigenschaften auch Festigkeitseigenschaften, Härteeigenschaften, elektrische Eigenschaften, magnetische Eigenschaften, optische Eigenschaften, Elastizitäten, etc. der Komponenten sein. Oberflächenbeschaffenheiten der Komponenten können beispielsweise Rauigkeiten, Texturen, Beschichtungen, Farben, Reflektivitäten, etc. der Komponenten sein.

Die physikalischen Komponenten-Eigenschaften können sich auf einzelne Komponenten oder Komponentengruppen beziehen. Beispielsweise können sich die physikalischen Eigenschaften auf einzelne Komponenten beziehen, aus denen größere, komplexere Komponentengruppen zusammengesetzt werden. Alternativ oder ergänzend können sich die Eigenschaften auch auf aus mehreren Komponenten zusammengesetzte komplexere Gerätschaften wie zum Beispiel Antriebsmotoren, Getriebeeinheiten, Förderketten, etc. beziehen.

Durch Simulationen ermittelte Werte, welche auf Daten des Digitaler-Doppelgänger-Datensatzes basieren, können das dynamische Verhalten der bewegbaren Komponenten in verschiedenen Betriebsabläufen repräsentieren, wie beispielsweise Beschleunigungswerte, Verzögerungswerte, das Schwingungsverhalten (Amplituden und Frequenzen der Komponenten und deren Änderungen über die Fahrstrecke), Kennwerte und von virtuell abgebildeten Sensoren zu erwartende Signale, die das korrekte Zusammenspiel der Komponenten wiedergeben, und dergleichen mehr.

Gemäß einer Ausführungsform können im Rahmen einer Konzeptionierung der Personentransportanlage für in der Personentransportanlage zu verbauende Komponenten Konzeptions-Solldaten erstellt werden, welche konzeptionsspezifische Soll-Eigenschaften der jeweiligen Komponente angeben. In dem Digitaler-Doppelgänger-Datensatz können dann die physikalischen Eigenschaften einer Komponente basierend auf deren Konzeptions-Solldaten angegeben sein.

Mit anderen Worten können die in dem Digitaler-Doppelgänger-Datensatz enthaltenen Daten Soll-Eigenschaften der Komponenten bzw. Bauteile wiedergeben, wie sie beispielsweise beim Planen, Konzipieren bzw. Kommissionieren der Personentransportanlage angenommen werden und wie sie beispielsweise aus hierbei verwendeten CAD-Daten betreffend die Komponenten bzw. Bauteile entnommen werden können. Diese Soll-Eigenschaften der Komponenten werden nachfolgend teilweise auch als Soll-Komponenten-Eigenschaften bezeichnet und der diese Daten enthaltende Digitaler-Doppelgänger-Datensatz wird teilweise auch als Konfigurations-Digitaler-Doppelgänger-Datensatz bezeichnet.

Beispielsweise ist es üblich, bei einer Planung, Konzipierung bzw. Kommissionierung einer Personentransportanlage die dabei verwendeten Komponenten und Bauteile mithilfe von Computern und unter Verwendung von CAD- Programmen zu planen oder zu designen, sodass entsprechende CAD-Daten beispielsweise eine Soll-Geometrie eines Bauteils wiedergeben. Allerdings geben solche als Konzeptions-Solldaten verwendeten CAD-Daten im Regelfall nicht an, welche Geometrie ein gefertigtes Bauteil tatsächlich hat, wobei beispielsweise Fertigungstoleranzen oder Ähnliches dazu führen können, dass sich die tatsächliche Geometrie signifikant von der Soll-Geometrie unterscheidet. Ferner geben die Konzeptions-Solldaten im Allgemeinen nicht wieder, welche physikalischen Eigenschaften eine Komponente letztendlich im installierten Zustand aufweist.

Die in dem Digitaler-Doppelgänger-Datensatz enthaltenen Daten sollen die physikalischen Soll-Komponenten-Eigenschaften der Komponenten ausreichend detailliert widerspiegeln, um daraus Aussagen über in der fertigen Personentransportanlage realisierte strukturelle und/oder funktionelle Eigenschaften der gesamten Personentransportanlage ableiten zu können. Insbesondere sollen anhand des digitalen Doppelgängers Aussagen über strukturelle und/oder funktionelle Eigenschaften, welche einen Zustand und/oder eine Funktionalität der gesamten Personentransportanlage charakterisieren, abgeleitet werden können, die für eine Beurteilung von deren zukünftigen Betriebseigenschaften, insbesondere von deren zukünftiger Betriebssicherheit, deren zukünftiger Verfügbarkeit und/oder einer zukünftigen Notwendigkeit für eine Wartung oder Reparatur, herangezogen werden können.

Der Konfigurations-Digitaler-Doppelgänger-Datensatz stellt somit ein virtuelles Abbild der Personentransportanlage in ihrer Planungsphase bzw. Kommissionierungsphase dar, d.h., bevor die Personentransportanlage tatsächlich gebaut und installiert wird.

Dabei kann ein Erstellen des Konfigurations-Digitaler-Doppelgänger-Datensatzes ein Erstellen von Konfigurationsdaten unter Berücksichtigung von Kundenspezifikationen sowie ein Erstellen von Fertigungsdaten durch Modifizieren der Konfigurationsdaten unter Berücksichtigung von Fertigungsspezifikationen umfassen. Mit anderen Worten können beim anfänglichen Erstellen des Konfigurations-Digitaler-Doppelgänger-Datensatzes sowohl Kundenspezifikationen als auch Fertigungsspezifikationen berücksichtigt werden. Dabei werden zunächst im Regelfall die Konfigurationsdaten unter Berücksichtigung der Kundenspezifikationen erstellt und dann diese Konfigurationsdaten unter Berücksichtigung der Fertigungsspezifikationen modifiziert bzw. verfeinert. Eventuell kann das Erstellen des Konfigurations-Digitaler-Doppelgänger-Datensatzes auch iterativ ein mehrfaches Berechnen und Modifizieren von Konfigurationsdaten unter Berücksichtigung der Kunden- und/oder Fertigungsspezifikationen umfassen.

Unter Kundenspezifikationen können dabei Vorgaben verstanden werden, welche Einzelfall-spezifisch vom Kunden zum Beispiel beim Ordern der Personentransportanlage vorgegeben werden. Die Kundenspezifikationen beziehen sich dabei typischerweise auf eine einzelne zu fertigende Personentransportanlage. Beispielsweise können die Kundenspezifikationen vorherrschende räumliche Bedingungen am Einbauort, Schnittstelleninformationen zum Anbau an tragende Strukturen eines Bauwerks, etc. umfassen. Anders ausgedrückt können die Kundenspezifikationen zum Beispiel angeben, welche Länge die Personentransportanlage haben soll, welcher Höhenunterschied überwunden werden soll, in welcher Weise die Personentransportanlage an tragende Strukturen innerhalb des Gebäudes angebunden werden soll, etc. Kundenspezifikationen können auch Wünsche des Kunden hinsichtlich Funktionalität, Förderkapazität, Optik, etc. umfassen. Die Konfigurationsdaten können beispielsweise als CAD-Datensatz vorliegen, welcher unter anderem geometrische Abmessungen und/oder andere physikalische Eigenschaften der die Personentransportanlage bildenden Bauteile wiedergibt.

Die Fertigungsspezifikationen beziehen sich typischerweise auf Eigenschaften oder Vorgaben innerhalb einer Fertigungsfabrik oder Fertigungslinie, in der die Personentransportanlage gefertigt werden soll. Beispielsweise können, zum Beispiel je nachdem in welchem Land oder an welchem Ort eine Fertigungsfabrik steht, in der Fertigungsfabrik verschiedene Bedingungen herrschen und/oder Vorgaben einzuhalten sein. Beispielsweise können in manchen Fertigungsfabriken bestimmte Materialien, Rohstoffe, Rohbauteile oder Ähnliches nicht verfügbar sein oder nicht verarbeitet werden. In manchen Fertigungsfabriken können Maschinen eingesetzt werden, die in anderen Fertigungsfabriken fehlen. Manche Fertigungsfabriken unterliegen aufgrund ihres Layouts Restriktionen hinsichtlich der darin zu fertigenden Personentransportanlagen bzw. Komponenten derselben. Manche Fertigungsfabriken ermöglichen einen hohen Grad an automatisierter Fertigung, wohingegen andere Fertigungsfabriken beispielsweise aufgrund niedriger Lohnkosten eher manuelle Fertigung einsetzen können. Es können noch eine Vielzahl weiterer Bedingungen und/oder Vorgaben existieren, bezüglich derer sich Fertigungsumgebungen unterscheiden können. All diese Fertigungsspezifikationen müssen typischerweise beim Planen bzw. Kommissionieren einer Personentransportanlage berücksichtigt werden, da von ihnen abhängig sein kann, in welcher Weise eine Personentransportanlage tatsächlich gebaut werden kann. Gegebenenfalls kann es erforderlich sein, anfänglich erstellte Konfigurationsdaten, welche lediglich die Kundenspezifikationen berücksichtigt hatten, grundlegend zu modifizieren, um den Fertigungsspezifikationen Rechnung tragen zu können.

Der Digitaler-Doppelgänger-Datensatz kann in einem zur Durchführung des hierin vorgeschlagenen Verfahrens konfigurierten Computer bzw. einer entsprechenden Datenverarbeitungsanlage gespeichert, analysiert und/oder verarbeitet werden. In dem Computer können gegebenenfalls ferner Simulationsprogramme ausgeführt werden, mithilfe derer unter Verwendung der Daten in dem Digitaler-Doppelgänger-Datensatz Eigenschaften und/oder Funktionalitäten der durch den Digitaler-Doppelgänger-Datensatz repräsentierten Personentransportanlage simuliert werden können. Insbesondere können der Computer bzw. die Datenverarbeitungsanlage entfernt von der zu inspizierenden Personentransportanlage, beispielsweise in einem entfernten Überwachungszentrum oder in einer Datenwolke (Cloud), angeordnet sein.

Gemäß einer Ausführungsform können im Rahmen einer Fertigung einer in der Personentransportanlage zu verbauenden Komponente der Personentransportanlage Fertigungs-Istdaten ermittelt werden, welche bei der Fertigung realisierte Ist-Eigenschaften der jeweiligen Komponente angeben. In dem Digitaler-Doppelgänger-Datensatz können die physikalischen Eigenschaften der Komponente dann basierend auf deren Fertigungs-Istdaten angegeben sein.

Mit anderen Worten kann die Konformitätsbewertung basierend auf einem Digitaler-Doppelgänger-Datensatz durchgeführt werden, in dem nicht oder nicht nur Konzeptions-Solldaten die Soll-Eigenschaften der Komponenten wiedergeben, sondern stattdessen oder ergänzend Fertigungs-Istdaten in dem Digitaler-Doppelgänger-Datensatz aufgenommen sind. Diese Fertigungs-Istdaten geben keine während der Konzeption vorgegebenen Soll-Eigenschaften vor, sondern spiegeln die sich während der Fertigung einer Komponente tatsächlich einstellenden Ist-Eigenschaften einer Komponente wider.

Die Fertigung-Istdaten können beispielsweise durch Vermessen einer tatsächlich gefertigten Komponente ermittelt werden. Da sich die Ist-Eigenschaften beispielsweise aufgrund von Toleranzen bei der Fertigung von den Soll-Eigenschaften unterscheiden können, kann der mit Fertigungs-Istdaten ergänzte Digitaler-Doppelgänger-Datensatz die physikalischen Eigenschaften der Komponenten der Personentransportanlage genauer wiedergeben, als dies bei dem Konzeptions-Digitaler-Doppelgänger-Datensatz der Fall ist. Dementsprechend können die Virtuell-Werte für das Ergebnisprotokoll genauer ermittelt werden.

Die Fertigungs-Istdaten können dabei zu einem Zeitpunkt ermittelt werden, zu dem eine Komponente zwar bereits gefertigt, aber noch nicht in der Personentransportanlage installiert ist. Dementsprechend kann die zumindest teilvirtualisierte Konformitätsbewertung zu einem frühen Zeitpunkt durchgeführt werden, insbesondere bevor Komponenten zu einem Einsatzort transportiert und/oder dort installiert werden. Sollten sich dabei Fehler bei der Konzeption und/oder der Fertigung von Komponenten entdecken lassen, können Maßnahmen früh ergriffen werden und somit Transportkosten und/oder Installationskosten eingespart werden.

Gemäß einer weiteren Ausführungsform können im Rahmen einer Installation von in der Personentransportanlage zu verbauenden Komponenten der Personentransportanlage in der Personentransportanlage Installations-Istdaten ermittelt werden, welche bei der Installation realisierte Ist-Eigenschaften der jeweiligen Komponente angeben. Dabei können in dem Digitaler-Doppelgänger-Datensatz die physikalischen Eigenschaften der Komponente basierend auf deren Installations-Istdaten angegeben sein.

Anders ausgedrückt können in dem Digitaler-Doppelgänger-Datensatz, der für die Konformitätsbewertung genutzt wird, statt oder ergänzend zu Konzeptions-Solldaten und/oder Fertigungs-Istdaten sogenannte Installations-Istdaten enthalten sein. Diese Installations-Istdaten geben sich tatsächlich einstellende physikalische Eigenschaften der in der Personentransportanlage enthaltenen Komponenten in einem Stadium wider, bei dem die Komponenten bereits in der Personentransportanlage installiert wurden.

Ähnlich wie die Fertigungs-Istdaten können auch die Installations-Istdaten durch Vermessen einer fertigen Komponente ermittelt werden, allerdings nachdem diese installiert wurde. Da durch die Installation einer Komponente deren physikalische Eigenschaften modifiziert werden können, kann der mit den Installations-Istdaten ergänzte Digitaler-Doppelgänger-Datensatz die physikalischen Eigenschaften der Komponenten in der fertig installierten Personentransportanlage genauer wiedergeben, als dies beispielsweise beim Konzeptions-Digitaler-Doppelgänger-Datensatz oder beim Fertigungs-Digitaler-Doppelgänger-Datensatz der Fall ist. Dementsprechend können die Virtuell-Werte für das Ergebnisprotokoll genauer die Ist-Eigenschaften der Personentransportanlage in ihrem fertig installierten Zustand wiedergeben.

Gemäß einer Ausführungsform können alle der bei der Konformitätsbewertung zu prüfenden Eigenschaften der Personentransportanlage aus dem Digitaler-Doppelgänger-Datensatz abgeleitet werden oder durch Simulationen basierend auf dem Digitaler-Doppelgänger-Datensatz ermittelt werden.

Mit anderen Worten kann die Konformitätsbewertung vollständig virtualisiert durchgeführt werden, d.h. alle dabei zu ermittelnden Eigenschaften der Personentransportanlage können ausschließlich durch Analyse der in dem Digitaler-Doppelgänger-Datensatz enthaltenen Informationen oder durch Simulationen unter Verwendung der Daten in dem Digitaler-Doppelgänger-Datensatz ermittelt werden. Somit kann die virtualisierte Konformitätsbewertung bereits zu einem Zeitpunkt durchgeführt werden, zu dem die Personentransportanlage zwar bereits vollständig konzipiert wurde und somit beispielsweise für jede der darin zu verbauenden Komponenten Komponenten-Soll-Eigenschaften festgelegt wurden, aber noch keinerlei Komponenten tatsächlich gefertigt und/oder installiert wurden. Sollten sich bei dieser rein virtualisierten Konformitätsbewertung Fehler oder Defizite bei der Personentransportanlage ermitteln lassen, kann diesen bereits in einem solchen frühen Stadium entgegengewirkt werden und dabei Kosten und/oder Aufwand für eine ansonsten durchgeführte Fertigung, Transport und/oder Installation vermieden werden.

Alternativ oder ergänzend kann gemäß einer Ausführungsform die Personentransportanlage als eine ihrer Komponenten eine Steuerung aufweisen, mit welcher andere Komponenten der Personentransportanlage zu steuern sind. Bei der Konformitätsbewertung kann dann einem sogenannten "Hardware in the loop- Ansatz", eine real existierende Steuerung mit einem Computer kommunizieren, in dem die zu steuernden Komponenten basierend auf Daten des Digitaler-Doppelgänger-Datensatz simuliert werden, um die simulierten Komponenten virtuell zu steuern. Die bei der Konformitätsbewertung zu prüfenden Eigenschaften der Personentransportanlage können dann einerseits aus physikalischen Eigenschaften der real existierenden Steuerung und andererseits aus physikalischen Eigenschaften der Komponenten, wie sie in dem Digitaler-Doppelgänger-Datensatz angegeben sind oder durch Simulationen basierend auf dem Digitaler-Doppelgänger-Datensatz zu ermitteln sind, abgeleitet werden.

Bei dieser Ausführungsform wird somit die Konformitätsbewertung nicht vollständig virtualisiert, d.h. vollständig basierend auf dem Digitaler-Doppelgänger-Datensatz, durchgeführt. Stattdessen existiert zumindest die Steuerung der Personentransportanlage als reale Komponente, wohingegen einige oder alle der sonstigen Komponenten der Personentransportanlage noch nicht real existieren, sondern mithilfe ihres digitalen Doppelgängers repräsentiert werden. Die nicht real existierenden Komponenten können dann in einem Computer nachgebildet bzw. simuliert werden. Die reale Steuerung kann mit diesem Computer beispielsweise über eine Datenschnittstelle kommunizieren. Beispielsweise kann die reale Steuerung Steuersignale oder Steuerbefehle über die Datenschnittstelle an den Computer leiten und in dem Computer können die basierend auf dem Digitaler-Doppelgänger-Datensatz simulierten Komponenten dann virtuell mithilfe dieser Steuersignale bzw. Steuerbefehle gesteuert werden. Dabei können durch gezieltes Ansteuern der simulierten Komponenten beispielsweise Funktionalitäten der gesamten Personentransportanlage simuliert werden und diese im Rahmen der teilvirtualisierten Konformitätsbewertung analysiert werden. Auf diese Weise kann beispielsweise überprüft werden, ob die real existierende Steuerung in einer gewünschten Weise arbeitet und mit der ansonsten nur virtuell existierenden restlichen Personentransportanlage und deren Komponenten in einer gewünschten Weise kommunizieren kann.

Gemäß einer Ausführungsform können zu prüfende Eigenschaften, welche allein basierend auf in dem Digitaler-Doppelgänger-Datensatz enthaltenen Informationen nicht oder nicht ausreichend abgeleitet werden können, mit vordefinierten Vorgabe-Eigenschaften in dem Ergebnisprotokoll angegeben werden.

Anders ausgedrückt können diejenigen der im Rahmen der Konformitätsbewertung zu prüfenden Eigenschaften, welche allein virtuell nicht oder zumindest nicht in ausreichender Weise ermittelt werden können, in dem Ergebnisprotokoll stellvertretend durch Vorgabe-Eigenschaften, d.h. durch sogenannte Default-Werte, angegeben werden.

"Nicht in ausreichender Weise aus dem Digitaler-Doppelgänger-Datensatz abzuleiten" kann hierbei dahingehend interpretiert werden, dass allein aus dem Digitaler-Doppelgänger-Datensatz oder durch Simulationen unter Verwendung des Digitaler-Doppelgänger-Datensatzes kein ausreichend zuverlässiger und/oder kein ausreichend genauer Rückschluss auf bestimmte der zu überprüfenden physikalischen Eigenschaften möglich ist.

Beispielsweise kann es im Rahmen einer Konformitätsbewertung gefordert sein, eine Notfallbremsung durchzuführen und dann Bremsspuren beispielsweise an einer Führungsschiene einer Aufzuganlage zu untersuchen. Eine solche Analyse der Notfallbremsung ist allein virtuell schwierig oder zumindest nicht ausreichend zuverlässig durchzuführen. Um die Konformitätsbewertung dennoch abschließen zu können, kann für die in diesem Fall zu prüfende Eigenschaften, d.h. das aufgrund einer Analyse der Bremsspuren zu prüfende Verhalten bei der Notfallbremsung, ein vordefinierter Vorgabe-Wert in das Ergebnisprotokoll aufgenommen werden.

Gemäß einer weiter konkretisierten Ausführungsform können dabei diejenigen Eigenschaften, die allein basierend auf in dem Digitaler-Doppelgänger-Datensatz enthaltenen Informationen nicht bzw. nicht ausreichend abgeleitet werden können, in dem Ergebnisprotokoll speziell gekennzeichnet werden.

Auf diese Weise kann später in dem Ergebnisprotokoll erkennbar sein, welche der darin aufgenommenen Virtuell-Werte nicht aus Daten des Digitaler-Doppelgänger-Datensatzes abgeleitet wurden bzw. mithilfe dieser simuliert wurden, sondern nur vordefinierte Vorgabe-Eigenschaften angeben.

Gemäß einer Ausführungsform kann zusätzlich zu der teilvirtualisierten Konformitätsbewertung nach Fertigstellung der Personentransportanlage ergänzend eine realitätsbasierte Konformitätsbewertung durchgeführt werden, bei der alle der bei der Konformitätsbewertung zu prüfenden Eigenschaften der Personentransportanlage an der realen Personentransportanlage ermittelt werden und ergänzend als Real-Werte in dem Ergebnisprotokoll angegeben werden.

Anders ausgedrückt kann zusätzlich zu einer möglicherweise zu einem früheren Zeitpunkt durchgeführten teilvirtualisierten Konformitätsbewertung ergänzend eine realitätsbasierte Konformitätsbewertung, wie sie den herkömmlich durchgeführten Konformitätsbewertungen entspricht, durchgeführt werden. Dabei werden die physikalischen Eigenschaften der Personentransportanlage an der realen, fertig installierten Personentransportanlage ermittelt, beispielsweise durch entsprechende physikalische Tests und/oder Messungen. Die dabei gefundenen physikalischen Eigenschaften können dann zusätzlich zu den zuvor mittels der virtuellen Konformitätsbewertung ermittelten Virtuell-Werte in dem Ergebnisprotokoll aufgenommen werden und als die realen physikalischen Eigenschaften der Personentransportanlage wiedergebende Real-Werte dienen.

Dabei können gemäß einer Ausführungsform vorteilhafterweise ergänzend die Virtuell-Werte mit den Real-Werten in dem Ergebnisprotokoll verglichen werden, um Defizite bei der Konzeptionierung und/oder der Realisierung der Personentransportanlage auch im Hinblick auf zukünftig zu erstellende Personentransportanlagen zu erkennen.

Mit anderen Worten kann für den Fall, dass sowohl eine zumindest teilvirtualisierte Konformitätsbewertung als auch eine realitätsbasierte Konformitätsbewertung durchgeführt werden, die dabei ermittelten Virtuell-Werte mit den ebenfalls ermittelten Real-Werten verglichen werden. Insbesondere wenn sich Unterschiede zwischen diesen Werten ergeben, kann dies einen Hinweis auf Mängel oder Fehler bei der Konzeptionierung und/oder bei der Realisierung, d.h. bei der Fertigung der Komponenten und/oder der Installation der Komponenten, andeuten. Diese Ergebnisse können dann im Produkt-Lebenszyklus-Management einfließen, um dessen Prozesse zu verbessern.

Gemäß einer konkreten Ausführungsform der Erfindung ist die Personentransportanlage eine Fahrtreppe oder ein Fahrsteig. Die Komponenten der Personentransportanlage sind in diesem Fall vorzugsweise Bauteile eines Fachwerks und Bauteile einer Fördereinrichtung. Die Bauteile eines Fachwerks können Obergurte, Untergurte, Steher, Querstreben, Diagonalstreben, Knotenbleche, Auflagewinkel und/oder Fachwerktrennstellen sein. Die Bauteile einer Fördereinrichtung können Fahrstufen, Fahrpaletten, Förderketten, Fördergurte, Antriebsmaschinen, Betriebsbremsen und/oder Steuerungen sein.

Mit anderen Worten kann eine Personentransportanlage in Form einer Fahrtreppe oder eines Fahrsteigs aus einer Vielzahl von Komponenten bzw. Bauteilen zusammengesetzt sein, die einerseits ein Fachwerk bilden, welches eine tragende Struktur der Personentransportanlage darstellt, und die andererseits eine Fördereinrichtung bilden, welche von dem Fachwerk gehalten wird und mithilfe derer Passagiere entlang eines Verfahrwegs befördert werden können. Sowohl das Fachwerk als auch die Fördereinrichtung sollten vor Inbetriebnahme durch eine Konformitätsbewertung hinsichtlich ihrer Eigenschaften überprüft werden, um beispielsweise Funktionalitäten feststellen bzw. sicherstellen zu können, die für eine Betriebssicherheit und/oder eine Verfügbarkeit der Fahrtreppe bzw. des Fahrsteigs wichtig sein können.

Ein Erstellen des aktuellen Digitaler-Doppelgänger-Datensatzes für die Fahrtreppe bzw. den Fahrsteig sowie ein Prüfen von Eigenschaften derselben können hierbei in analoger Weise ausgestaltet sein, wie dies hierin alternativ für die Ausgestaltung der Personentransportanlage als Aufzug beschrieben wird.

Gemäß einer alternativen Ausführungsform der Erfindung ist die Personentransportanlage ein Aufzug. Die Komponenten der Personentransportanlage können hierbei Bauteile einer Tragestruktur und/oder Bauteile einer Förderstruktur sein. Die Bauteile der Tragestruktur können Führungsschienen, Wandbefestigungen, Trägerrahmen, Bodenbefestigungen, Querverstrebungen, Längsverstrebungen und/oder Diagonalverstrebungen sein. Die Bauteile einer Förderstruktur können Aufzugkabinen, Gegengewichte, Tragmittel, Antriebsmaschinen, Bremsvorrichtungen und/oder Steuerungen sein.

Konkrete Ausgestaltungen, wie ein aktueller Digitaler-Doppelgänger-Datensatz für einen Aufzug erstellt werden kann und wie darauf basierend Eigenschaften des Aufzugs mittels einer zumindest teilvirtualisierten Konformitätsbewertung geprüft werden können, werden weiter unten mit Bezug auf bevorzugte Ausführungsformen dargelegt.

Ausführungsformen des hierin vorgestellten Verfahrens zum Durchführen einer zumindest teilvirtualisierten Konformitätsbewertung bei einer Personentransportanlage können mithilfe einer hierfür speziell konfigurierten Vorrichtung durchgeführt werden. Die Vorrichtung kann einen oder mehrere Computer umfassen. Insbesondere kann die Vorrichtung aus einem Computernetzwerk gebildet sein, welches Daten in Form einer Datenwolke (Cloud) verarbeitet. Die Vorrichtung kann hierfür über einen Speicher verfügen, in dem die Daten des Digitaler-Doppelgänger-Datensatzes gespeichert werden können, beispielsweise in elektronischer oder magnetischer Form. Die Vorrichtung kann ferner über Datenverarbeitungsmöglichkeiten verfügen. Beispielsweise kann die Vorrichtung einen Prozessor aufweisen, mithilfe dessen Daten des Digitaler-Doppelgänger-Datensatzes verarbeitet werden können. Die Vorrichtung kann ferner über Schnittstellen verfügen, über die Daten in die Vorrichtung eingegeben und/oder aus der Vorrichtung ausgegeben werden können. Eventuell kann die Vorrichtung mit Sensoren verbunden sein, die an oder in der Personentransportanlage angeordnet sind und mithilfe derer physikalische Eigenschaften von Bauteilen der Personentransportanlage gemessen werden können. Die Vorrichtung kann prinzipiell Teil der Personentransportanlage sein. Vorzugsweise ist die Vorrichtung jedoch nicht in der Personentransportanlage angeordnet, sondern entfernt zu dieser angeordnet, beispielsweise in einem entfernten Kontrollzentrum, von dem aus der Zustand der Personentransportanlage überwacht werden soll. Die Vorrichtung kann auch räumlich verteilt implementiert sein, beispielsweise wenn Daten über mehrere Computer verteilt in einer Datenwolke verarbeitet werden.

Insbesondere kann die Vorrichtung programmierbar sein, d.h. durch ein geeignet programmiertes Computerprogrammprodukt dazu veranlasst werden, das erfindungsgemäße Verfahren auszuführen oder zu steuern. Das Computerprogrammprodukt kann Anweisungen oder Code enthalten, welche beispielsweise den Prozessor der Vorrichtung dazu veranlassen, Daten des Digitaler-Doppelgänger-Datensatzes abzuspeichern, auszulesen, zu verarbeiten, zu modifizieren, basierend auf diesem Simulationen durchzuführen, etc. Das Computerprogrammprodukt kann in einer beliebigen Computersprache verfasst sein.

Das Computerprogrammprodukt kann auf einem beliebigen computerlesbaren Medium gespeichert sein, beispielsweise einem Flash-Speicher, einer CD, einer DVD, RAM, ROM, PROM, EPROM, etc. Das Computerprogrammprodukt und/oder die damit zu verarbeitenden Daten können auch auf einem Server oder mehreren Servern gespeichert sein, beispielsweise einer Datenwolke, von wo aus sie über ein Netzwerk, beispielsweise das Internet, heruntergeladen werden können.

Abschließend wird darauf hingewiesen, dass einige der möglichen Merkmale und Vorteile der Erfindung hierin mit Bezug auf unterschiedliche Ausführungsformen sowohl des vorgeschlagenen Verfahrens als auch der entsprechend ausgebildeten Vorrichtung zum Durchführen einer zumindest teilvirtualisierten Akzeptanzprüfung bei einer Personentransportanlage beschrieben sind. Ein Fachmann erkennt, dass die Merkmale in geeigneter Weise kombiniert, übertragen, angepasst oder ausgetauscht werden können, um zu weiteren Ausführungsformen der Erfindung zu gelangen.

Nachfolgend wird eine Ausführungsform der Erfindung unter Bezugnahme auf die beigefügte Zeichnung beschrieben, wobei weder die Zeichnung noch die Beschreibung als die Erfindung einschränkend auszulegen sind.

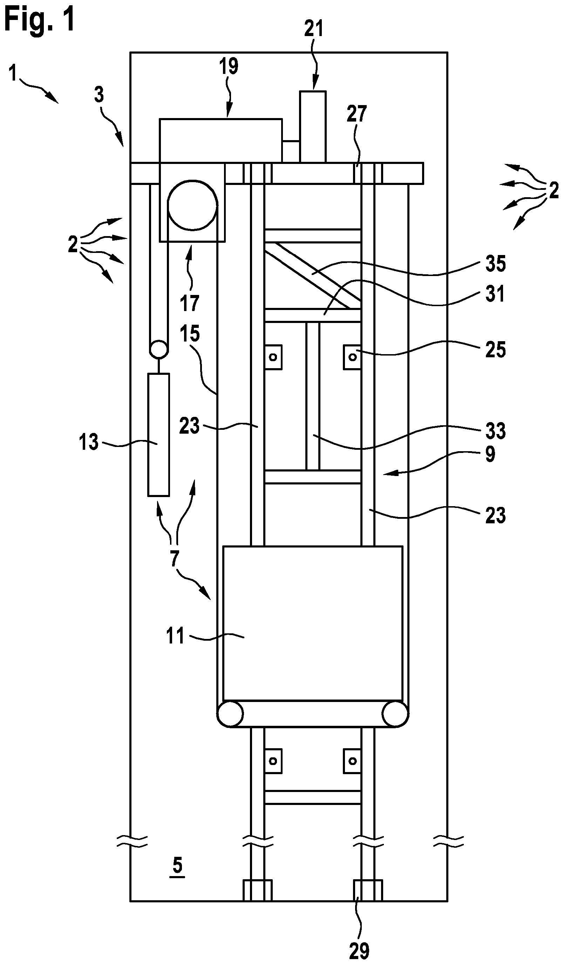

Figur 1 zeigt eine Personentransportanlage in Form eines Aufzugs, bezüglich dem ein erfindungsgemäßes Verfahren durchgeführt werden kann. Die Figur 1 ist lediglich schematisch und nicht maßstabsgetreu. Gleiche Bezugszeichen bezeichnen gleiche oder gleichwirkende Merkmale.

Zunächst wird eine im Rahmen einer Konformitätsbewertung zu prüfende Personentransportanlage hinsichtlich der darin eingesetzten Komponenten und Bauteile kurz und lediglich sehr schematisch beschrieben.

Wie in Figur 1 dargestellt, ist in einer Ausgestaltung die Personentransportanlage 1 als Aufzug 3 ausgebildet. Der Aufzug 3 verfügt über einen Aufzugschacht 5, in dem eine Fördereinrichtung 7 und eine diese Fördereinrichtung 7 haltende Tragestruktur 9 aufgenommen sind. Eine Aufzugkabine 11 und ein Gegengewicht 13 sind an Tragmitteln 15 in Form von Riemen aufgehängt. Eine Antriebsmaschine 17 sowie eine Bremsvorrichtung 19 treiben die Tragmittel 15 an beziehungsweise bremsen diese bei Bedarf. Eine Steuerung 21 steuert den Betrieb des Aufzugs 3, insbesondere von dessen Antriebsmaschine 17 sowie dessen Bremsvorrichtung 19. Die Aufzugkabine 11 und gegebenenfalls auch das Gegengewicht 13 werden bei ihrer Bewegung durch den Aufzugschacht 5 mithilfe von Führungsschienen 23 geführt. Die Führungsschienen 23 sind über Wandbefestigungen 25, Trägerrahmen 27 und Bodenbefestigungen 29 mit tragenden Strukturen innerhalb des Aufzugschachts 5 verbunden. Ferner sorgen eventuell Querverstrebungen 31, Längsverstrebungen 33 und Diagonalverstrebungen 35 für eine ausreichende mechanische Stabilisierung der Führungsschienen 23. Die beispielhaft genannten Einrichtungen sowie möglicherweise weitere Einrichtungen werden hierin auch als Komponenten 2 (in Figur 1 mit einem Bezugszeichen nur schematisch angedeutet) der Personentransportanlage 1 bezeichnet.

Herkömmlich werden Aufzüge 3 individualisiert für einen Einsatzzweck konzipiert. Angepasst beispielsweise an die Bedingungen in dem mit einem Aufzug 3 zu versorgenden Gebäude, einem von einem Betreiber erstellten Lastenheft, in dem Anforderungen beispielsweise an Funktionalitäten, Förderkapazitäten und ähnliches angegeben sind, sowie durch Regularien oder Gesetze geregelte Vorgaben werden während einer Konzeptionsphase die für den individuellen Aufzug 3 benötigten Komponenten 2 hinsichtlich ihrer physikalischen Komponenten-Soll-Eigenschaften geplant. Die Konzeption und die dabei durchgeführte Auslegung der Komponenten 2 werden dabei meist mittels eines Computers durchgeführt. Der Computer kann Zugriff auf eine Datenbank haben, in der physikalische Eigenschaften von vorkonfektionierten Komponenten und/oder von für individuelle Einsatzzwecke herstellbaren Komponenten abgelegt sind. Ergänzend oder alternativ kann auf dem Computer beispielsweise ein CAD-Programm eingesetzt werden, um die Komponenten und deren Komponenten-Soll-Eigenschaften konzipieren zu können.

Die derart konzipierten Komponenten werden anschließend gefertigt, an den Einsatzort transportiert und schließlich dort installiert, das heißt miteinander verbunden und in das zu versorgenden Gebäude integriert.

Vor einer Übergabe an den Betreiber und einer Inbetriebnahme der Personentransportanlage 1 wird diese generell einer Konformitätsbewertung unterzogen. Dabei wird einem Prüfprotokoll folgend geprüft, ob die Personentransportanlage 1 vordefinierten Soll-Vorgaben entspricht.

Im zuvor dargestellten Beispiel eines Aufzugs 3 kann im Rahmen der Konformitätsbewertung beispielsweise geprüft werden, ob die Komponenten 2 der Tragestruktur 9, d.h. insbesondere die Quer-, Längs- und Diagonalverstrebungen 31, 33, 35 sowie die Wand-, Decken- und Bodenbefestigungen 25, 27, 29, korrekt dimensioniert wurden, korrekt zusammenwirken können und korrekt installiert wurden, um physikalische Soll-Eigenschaften wie beispielsweise eine mechanische Belastbarkeit zu erreichen. Auch physikalische Eigenschaften der Aufzugkabine 11, des Gegengewichts 13, der sie verbindenden Tragmittel 15, der die Tragmittel 15 antreibenden Antriebsmaschine 17, der Bremsvorrichtungen 19 sowie Funktionen der diese Komponenten 2 steuernden Steuerung 21 können durch verschiedene während der Konformitätsbewertung durchzuführende Tests ermittelt bzw. überprüft werden. Beispielsweise kann die Steuerung 21 die Antriebsmaschine 17 dazu ansteuern, die Aufzugkabine 11 und das Gegengewicht 13 an bestimmte Positionen und/oder mit bestimmten Geschwindigkeiten zu verlagern und es kann überprüft werden, ob die Verlagerungsbewegungen dabei anforderungsgemäß durchgeführt werden. Auch Bremsvorgänge, die insbesondere für den sicheren Betrieb des Aufzugs 3 essenziell sind, können gezielt angesteuert werden und überprüft werden, ob die Bremsvorgänge anforderungsgemäß durchgeführt werden.

Um die Konformitätsbewertung nicht erst nach fertiger Installation der Personentransportanlage 1 durchführen zu können, wird ein Verfahren zum Durchführen einer zumindest teilvirtualisierten Konformitätsbewertung vorgeschlagen.

Hierfür wird ein die individualisiert konzipierte Personentransportanlage 1 abbildender Digitaler-Doppelgänger-Datensatz erstellt. In dem Digitaler-Doppelgänger-Datensatz sind physikalische Eigenschaften von Komponenten 2 der Personentransportanlage 1 in maschinen-verarbeitbarer Weise wiedergegeben.

Beispielsweise können hierfür in den Digitaler-Doppelgänger-Datensatz diejenigen Daten aufgenommen werden, die in der Konzeptionsphase als Konzeptions-Solldaten für die Komponenten 2 der individuellen Personentransportanlage 1 festgelegt wurden. Konkret kann der Digitaler-Doppelgänger-Datensatz unter Verwendung der während der Konzeptionsphase ermittelten CAD-Daten für die Personentransportanlage 1 erstellt werden.

Erläutert am Beispiel der obigen Personentransportanlage 1 in Form des Aufzugs 3 können in dem Digitaler-Doppelgänger-Datensatz beispielsweise Daten betreffend physikalische Eigenschaften der verschiedenen Befestigungen 25, 27, 29 und Verstrebungen 31, 33, 35 wie beispielsweise Daten zu Geometrien, Abmessungen, verwendeten Materialien und deren Materialeigenschaften, Oberflächenbeschaffenheiten und Ähnliches aufgenommen sein. Ähnliche Daten können auch für die Aufzugkabine 11, das Gegengewicht 13 und die Tragmittel 15 im Digitaler-Doppelgänger-Datensatz aufgenommen sein. Für die Antriebsmaschine 17, die Bremsvorrichtungen 19 sowie die Steuerung 21 können ergänzend zu solchen Daten auch Daten beispielsweise betreffend eine elektrische Auslegung dieser Komponenten 2 und/oder weitere Daten betreffend zum Beispiel Funktionalitäten, wie sie von diesen Komponenten 2 zu implementieren sind, im Digitaler-Doppelgänger-Datensatz aufgenommen werden.

Weitere Möglichkeiten sowie Details zu einer Erstellung eines Digitaler-Doppelgänger-Datensatzes und daraus resultierender anschließender Verwendungsmöglichkeiten sind in einer früheren Patentanmeldung WO 2019/115378 A1 der Anmelderin der vorliegenden Patentanmeldung dargelegt und können analog oder in angepasster Weise auch für die Erstellung eines Digitaler-Doppelgänger-Datensatzes, wie er für die vorliegend beschriebene Erfindung nutzbar ist, eingesetzt werden. Der Inhalt der früheren Anmeldung wird daher vollumfänglich durch Inbezugnahme in die vorliegende Anmeldung aufgenommen.

Unter Nutzung des zuvor erzeugten Digitaler-Doppelgänger-Datensatzes kann im Rahmen der teilvirtualisierten Konformitätsbewertung dann bereits bevor die Personentransportanlage fertiggestellt ist oder sogar bevor deren Komponenten gefertigt wurden geprüft werden, ob ausgehend von den in dem Digitaler-Doppelgänger-Datensatz wiedergegebenen physikalischen Eigenschaften der konzeptionsmäßig in der Personentransportanlage genutzten Komponenten davon ausgegangen werden kann, dass resultierende Eigenschaften der damit gefertigten Personentransportanlage vordefinierten Soll-Vorgaben genügen.

Hierfür können aus dem Digitaler-Doppelgänger-Datensatz Werte abgeleitet werden, welche Angaben über die zu prüfenden Eigenschaften der Personentransportanlage erlauben. Alternativ oder ergänzend können unter Nutzung der in dem Digitaler-Doppelgänger-Datensatz enthaltenen Daten Computersimulationen durchgeführt werden, in denen Eigenschaften der Personentransportanlage simuliert werden und daraus Werte ermittelt werden, die diese zu prüfenden Eigenschaften wiedergeben.

Die ermittelten Werte können dann als Virtuell-Werte in einem Ergebnisprotokoll abgelegt werden. Durch Analyse dieser Werte kann letztendlich beispielsweise entschieden werden, ob die Personentransportanlage 1 korrekt konzeptioniert wurde.

Im Unterschied zu einer herkömmlichen Konformitätsbewertung existiert im Zeitpunkt der Durchführung des hier vorgestellten Verfahrens die Personentransportanlage 1 vorzugsweise noch nicht vollständig als physische Einrichtung. Stattdessen sind zumindest Teile der Personentransportanlage 1 lediglich als virtuelles Modell existent und werden durch den digitalen Doppelgänger der Personentransportanlage 1 wiedergegeben.

In dem Digitaler-Doppelgänger-Datensatz können die Komponenten 2, die diese Teile der Personentransportanlage 1 bilden, jedoch hinsichtlich ihrer physikalischen Eigenschaften so genau wiedergegeben bzw. modelliert werden, dass unter Zuhilfenahme des virtuellen Modells die Konformitätsbewertung in ähnlicher Weise durchgeführt werden kann, wie dies bei der herkömmlichen realitätsbasierten Konformitätsbewertung der Fall war. Insbesondere können einzelne Konformitätsbewertungsschritte an dem virtuellen Modell bzw. unter Zuhilfenahme des virtuellen Modells in analoger Weise durchgeführt werden, wie dies bei der realitätsbasierten Konformitätsbewertung der Fall ist. Dabei kann dem gleichen bzw. einem analog angepassten Prüfprotokoll wie bei der realitätsbasierten Konformitätsbewertung gefolgt werden.

Falls gewünscht kann das durch die teilvirtualisierte Konformitätsbewertung generierte Ergebnisprotokoll verbessert werden, indem die für dieses ermittelten Virtuell-Werte nicht nur basierend auf Konzeptions-Solldaten, welche konzeptionsspezifische Soll-Eigenschaften von Komponenten angeben, sondern ergänzend oder ersetzend basierend auf Fertigungs-Istdaten, welche bei der Fertigung realisierte Ist-Eigenschaften der jeweiligen Komponenten angeben, oder eventuell sogar basierend auf Installation-Istdaten, welche bei der Installation realisierte Ist-Eigenschaften der jeweiligen Komponenten angeben. Hierdurch kann in dem Digitaler-Doppelgänger-Datensatz insbesondere berücksichtigt werden, dass es bei der Fertigung von Komponenten und/oder bei deren Installation zu Unterschieden bei deren physikalischen Eigenschaften im Vergleich zu den in den Konzeptions-Solldaten angegebenen Soll-Eigenschaften kommen kann. Eine virtualisierte Konformitätsbewertung basierend auf dem mit den Istdaten versehenen Digitaler-Doppelgänger-Datensatz kann somit noch genaueren Aufschluss darüber geben, ob Eigenschaften der Personentransportanlage Soll-Vorgaben entsprechen.

Sofern im Rahmen der zumindest teilvirtualisierten Konformitätsbewertung bestimmte zu prüfende Eigenschaften nicht zuverlässig oder nicht ausreichend genau abgeleitet werden können, können für diese Eigenschaften in dem Ergebnisprotokoll vordefinierte Vorgabe-Eigenschaften ("Default-Werte") angegeben werden. Dies kann eventuell in dem Ergebnisprotokoll speziell gekennzeichnet werden, um eine spätere Auswertung zu vereinfachen und insbesondere erkennen zu können, dass einige der Werte in dem Ergebnisprotokoll nicht tatsächliche Resultate eines zuverlässig durchzuführenden Konformitätsbewertungsschrittes sind.

Gegebenenfalls kann nach Fertigstellung der Personentransportanlage 1 ergänzend zu einer oder mehreren zumindest teilvirtualisierten Konformitätsbewertungen auch eine realitätsbasierte Konformitätsbewertung durchgeführt werden und die dabei ermittelten Eigenschaften der Personentransportanlage als Real-Werte in dem Ergebnisprotokoll angegeben werden. Diese Real-Werte können dann mit den Virtuell-Werten verglichen werden, um Defizite bei der Konzeptionierung und/oder Fertigung und/oder Installation von Komponenten 2 für die Personentransportanlage 1 erkennen zu können. Hierzu können Abweichungskriterien im Digitaler-Doppelgänger-Datensatz hinterlegt sein, bei deren Überschreitung die entsprechenden ermittelten Werte als defizitbehaftet im Ergebnisprotokoll hervorgehoben werden.

Mit dem hierin beschriebenen Ansatz einer zumindest teilvirtualisierten Konformitätsbewertung können neben der bereits beschriebenen Möglichkeit, Defizite oder Fehler bei der Konzeptionierung, der Fertigung und/oder der Installation von Komponenten der Personentransportanlage erkennen zu können, verschiedene weitere Vorteile erreicht werden. Beispielsweise können die in dem Ergebnisprotokoll aufgenommenen Virtuell-Werte in dem Digitaler-Doppelgänger-Datensatz gespeichert werden und dann über die Lebenszeit von Komponenten oder Einrichtungsteilen genutzt werden, um Veränderungen und insbesondere Verschlechterungen detektieren zu können. Die Qualität von Komponenten und Einrichtungsteilen kann konsistent gesteigert werden, da potentielle Probleme sehr früh detektiert werden können, idealerweise beispielsweise bevor Material zum Einsatzort transportiert wird. Es können gegebenenfalls auch Eigenschaften von Einrichtungsteilen basierend auf sehr klaren Kriterien in einfacher Weise nachvollzogen werden. Außerdem kann dadurch, dass Virtuell-Werte und Real-Werte aus dem Ergebnisprotokoll eventuell miteinander verglichen werden können, idealerweise ein Muster abgeleitet werden, welches angibt, welche der bei der Konformitätsbewertung durchgeführten Tests eventuell nicht relevant sind, da beispielsweise ihre Ergebnisse immer den Soll-Vorgaben entsprechen. Es können auch Hinweise darauf abgeleitet werden, welche Eigenschaften, die zu Problemen führen können, ergänzend getestet werden sollten. Insgesamt ermöglicht die Verwendung der Daten aus dem digitalen Doppelgänger der Personentransportanlage verschiedene Arten von Analysen.

Für einen Hersteller einer Personentransportanlage wird dadurch eine hohe Produktqualität aufgrund der Möglichkeit einer frühen Erkennung von Problemen bei der Planung und Herstellung der Personentransportanlage ermöglicht. Beispielsweise können Probleme bei der Konfiguration erkannt werden und frühzeitig korrigiert werden, wodurch Installations- und Kommissionierungszeit gespart werden kann. Es kann auch eine bessere Nachverfolgbarkeit erreicht werden, indem für jede spezifische Installation die Ergebnisse aus der virtuellen Konformitätsbewertung mit denjenigen aus der realitätsbasierten Konformitätsbewertung verglichen werden. Schließlich wird auch eine Analyse großer Datenmengen (big data analysis) ermöglicht, bei der beispielsweise der Digitaler-Doppelgänger-Datensatz sowie die Werte in dem Ergebnisprotokoll einer sehr detaillierten Produktkonfiguration zugeordnet werden können.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Verfahren zum Durchführen einer zumindest teilvirtualisierten Konformitätsbewertung an einer Personentransportanlage (1),
wobei die Konformitätsbewertung einem vorgegebenen Prüfprotokoll folgend vor Übergabe der Personentransportanlage (1) an einen Nutzer durchgeführt wird,
wobei die Personentransportanlage (1) vorab individualisiert für einen Einsatzzweck mit einer Vielzahl von Komponenten (2) konzipiert wurde,
wobei ein die individualisiert konzipierte Personentransportanlage (1) abbildender Digitaler-Doppelgänger-Datensatz erstellt ist, in welchem physikalische Eigenschaften von Komponenten (2) der Personentransportanlage (1) in maschinen-verarbeitbarer Weise wiedergegeben sind,
wobei bei der Konformitätsbewertung geprüft wird, ob Eigenschaften der Personentransportanlage (1) Soll-Vorgaben entsprechen, welche zumindest eine korrekte Funktion der Komponenten (2) und/oder eine korrekte Kooperation der Komponenten (2) untereinander und/oder sicherheitsrelevante Eigenschaften der Personentransportanlage (1) definieren,
wobei bei der Durchführung der Konformitätsbewertung zumindest einige der bei der Konformitätsbewertung zu prüfenden, auf physikalischen Eigenschaften von Komponenten (2) basierenden Eigenschaften der Personentransportanlage (1), im Rahmen von virtualisierten Konformitätsbewertungsschritten durch Ableiten von Werten aus dem Digitaler-Doppelgänger-Datensatz oder durch Simulationen basierend auf dem Digitaler-Doppelgänger-Datensatz ermittelt werden und als Virtuell-Werte in einem Ergebnisprotokoll angegeben werden.

2. Verfahren nach Anspruch 1,
wobei im Rahmen einer Konzeptionierung der Personentransportanlage (1) für in der Personentransportanlage (1) zu verbauende Komponenten Konzeptions-Solldaten erstellt werden, welche konzeptionsspezifische Soll-Eigenschaften der jeweiligen Komponente (2) angeben, und wobei in dem Digitaler-Doppelgänger-Datensatz die physikalischen Eigenschaften einer Komponente (2) basierend auf deren Konzeptions-Solldaten angegeben sind.

3. Verfahren nach einem der vorangehenden Ansprüche,
wobei im Rahmen einer Fertigung einer in der Personentransportanlage (1) zu verbauenden Komponente (2) der Personentransportanlage Fertigungs-Istdaten ermittelt werden, welche bei der Fertigung realisierte Ist-Eigenschaften der jeweiligen Komponente (2) angeben, und wobei in dem Digitaler-Doppelgänger-Datensatz die physikalischen Eigenschaften der Komponente (2) basierend auf deren Fertigungs-Istdaten angegeben sind.

4. Verfahren nach einem der vorangehenden Ansprüche,
wobei im Rahmen einer Installation von in der Personentransportanlage (1) zu verbauenden Komponenten (2) der Personentransportanlage (1) in der Personentransportanlage (1) Installations-Istdaten ermittelt werden, welche bei der Installation realisierte Ist-Eigenschaften der jeweiligen Komponente (2) angeben, und wobei in dem Digitaler-Doppelgänger-Datensatz die physikalischen Eigenschaften der Komponente (2) basierend auf deren Installations-Istdaten angegeben sind.

5. Verfahren nach einem der vorangehenden Ansprüche,
wobei alle der bei der Konformitätsbewertung zu prüfenden Eigenschaften der Personentransportanlage (1) aus dem Digitaler-Doppelgänger-Datensatz abgeleitet oder durch Simulationen basierend auf dem Digitaler-Doppelgänger-Datensatz ermittelt werden.

6. Verfahren nach einem der vorangehenden Ansprüche,
wobei die Personentransportanlage (1) als eine ihrer Komponenten (2) eine Steuerung (21), mit welcher andere Komponenten (2) der Personentransportanlage (1) zu steuern sind, aufweist,
wobei bei der Konformitätsbewertung eine real existierende Steuerung (21) mit einem Computer kommuniziert, in dem die zu steuernden Komponenten (2) basierend auf Daten des Digitaler-Doppelgänger-Datensatz simuliert werden, um die simulierten Komponenten (2) virtuell zu steuern,
wobei die der bei der Konformitätsbewertung zu prüfenden Eigenschaften der Personentransportanlage (1) einerseits aus physikalischen Eigenschaften der real existierenden Steuerung (21) und andererseits aus physikalischen Eigenschaften der Komponenten (2), wie sie in dem Digitaler-Doppelgänger-Datensatz angegeben oder durch Simulationen basierend auf dem Digitaler-Doppelgänger-Datensatz zu ermittelt sind, abgeleitet werden.

7. Verfahren nach einem der vorangehenden Ansprüche,
wobei zu prüfende Eigenschaften, welche allein basierend auf in dem Digitaler-Doppelgänger-Datensatz enthaltenen Informationen nicht ausreichend abgeleitet werden können, mit vordefinierten Vorgabe-Eigenschaften in dem Ergebnisprotokoll angegeben werden.

8. Verfahren nach Anspruch 7,
wobei die Eigenschaften, die allein basierend auf in dem Digitaler-Doppelgänger-Datensatz enthaltenen Informationen nicht ausreichend abgeleitet werden können, in dem Ergebnisprotokoll speziell gekennzeichnet werden.

9. Verfahren nach einem der vorangehenden Ansprüche,
wobei zusätzlich zu der teilvirtualisierten Konformitätsbewertung nach Fertigstellung der Personentransportanlage (1) ergänzend eine realitätsbasierte Konformitätsbewertung durchgeführt wird, bei der alle der bei der Konformitätsbewertung zu prüfenden Eigenschaften der Personentransportanlage (1) an der realen Personentransportanlage (1) ermittelt werden und ergänzend als Real-Werte in dem Ergebnisprotokoll angegeben werden.

10. Verfahren nach Anspruch 9,
wobei ergänzend die Virtuell-Werte mit den Real-Werten in dem Ergebnisprotokoll verglichen werden, um Defizite bei der Konzeptionierung und/oder der Realisierung der Personentransportanlage (1) zu erkennen.

11. Verfahren nach einem der vorangehenden Ansprüche,
wobei die Personentransportanlage (1) ausgewählt ist aus einer Gruppe umfassend Fahrtreppen und Fahrsteige und wobei die Komponenten (2) der Personentransportanlage (1) ausgewählt sind aus einer Gruppe umfassend:
- Komponenten eines Fachwerks umfassend mehrere Komponenten ausgewählt aus einer Untergruppe umfassend Obergurte, Untergurte, Steher, Querstreben, Diagonalstreben, Knotenbleche, Auflagewinkel und Fachwerktrennstellen; und
- Komponenten einer Fördereinrichtung umfassend wenigstens eine Komponente ausgewählt aus einer Untergruppe umfassend Fahrstufen, Fahrpaletten, Förderketten, Fördergurte, Umlenkkettenräder, Umlenkscheiben, Antriebsmaschinen, Betriebsbremsen und Steuerungen.

12. Verfahren nach einem der vorangehenden Ansprüche 1 bis 10,
wobei die Personentransportanlage (1) ein Aufzug (3) ist und wobei die Komponenten (2) der Personentransportanlage (1) ausgewählt sind aus einer Gruppe umfassend:
- Komponenten einer Tragestruktur (9) umfassend mehrere Komponenten (2) ausgewählt aus einer Untergruppe umfassend Führungsschienen (23), Wandbefestigungen (25), Trägerrahmen (27), Bodenbefestigungen (29), Querverstrebungen (31), Längsverstrebungen (33) und Diagonalverstrebungen (35); und
- Komponenten einer Fördereinrichtung (7) umfassend wenigstens eine Komponente (2) ausgewählt aus einer Untergruppe umfassend Aufzugkabinen (11), Gegengewichte (13), Tragmittel (15), Antriebsmaschinen (17), Bremsvorrichtungen (19) und Steuerungen (21).

13. Vorrichtung zum Durchführen einer zumindest teilvirtualisierten Konformitätsbewertung bei einer Personentransportanlage (1), wobei die Vorrichtung dazu konfiguriert ist, ein Verfahren gemäß einem der Ansprüche 1 bis 8 durchzuführen oder zu steuern.

14. Computerprogrammprodukt, umfassend maschinenlesbare Programmanweisungen, welche bei Ausführung auf einer programmierbaren Vorrichtung die Vorrichtung zum Durchführen oder Steuern eines Verfahrens gemäß einem der Ansprüche 1 bis 8 veranlassen.

15. Computerlesbares Medium mit einem darauf gespeicherten Computerprogrammprodukt gemäß Anspruch 14.

## Claims

1. Method for carrying out an at least partially virtualized conformity assessment on a passenger transport system (1),
wherein the conformity assessment is carried out in accordance with a predetermined test protocol before the passenger transport system (1) is handed over to a user, wherein the passenger transport system (1) was designed in advance, individually for a particular purpose, having a plurality of components (2),
wherein a digital replica dataset is created, which depicts the individually designed passenger transport system (1) and in which physical properties of components (2) of the passenger transport system (1) are reproduced in a machine-processable manner, wherein, during the conformity assessment, it is tested whether the properties of the passenger transport system (1) correspond to target specifications which define at least a correct function of the components (2) and/or a correct cooperation of the components (2) with one another and/or safety-relevant properties of the passenger transport system (1), wherein, when carrying out the conformity assessment, at least some of the properties of the passenger transport system (1) that are to be tested during the conformity assessment and are based on physical properties of components (2) are determined in the context of virtualized conformity assessment steps by deriving values from the digital replica dataset or by simulations based on the digital replica dataset, and indicated as virtual values in a results log.

2. Method according to claim 1,
wherein, in the context of conceptually designing the passenger transport system (1), conceptual target data are created for components that are to be installed in the passenger transport system (1), which data indicate concept-specific target properties of the relevant component (2), and wherein the physical properties of a component (2) are indicated in the digital replica dataset on the basis of their conceptual target data.

3. Method according to any of the preceding claims,
wherein, in the context of manufacturing a component (2) of the passenger transport system (1) that is to be installed in the passenger transport system, actual manufacturing data are determined, which indicate actual properties of the relevant component (2) that are produced during manufacturing, and wherein the physical properties of the component (2) are indicated in the digital replica dataset on the basis of their actual manufacturing data.

4. Method according to any of the preceding claims,
wherein, in the context of installing components (2) of the passenger transport system (1) that are to be installed in the passenger transport system (1), actual installation data are determined in the passenger transport system (1), which data indicate actual properties of the relevant component (2) that are produced during installation, and wherein the physical properties of the component (2) are indicated in the digital replica dataset on the basis of their actual installation data.

5. Method according to any of the preceding claims,
wherein all of the properties of the passenger transport system (1) that are to be tested during the conformity assessment are derived from the digital replica dataset or are determined by simulations based on the digital replica dataset.

6. Method according to any of the preceding claims,
wherein the passenger transport system (1) has, as one of its components (2), a controller (21) by means of which other components (2) of the passenger transport system (1) are to be controlled,
wherein, during the conformity assessment, a real existing controller (21) communicates with a computer in which the components (2) to be controlled are simulated on the basis of data from the digital replica dataset in order to virtually control the simulated components (2),
wherein the properties of the passenger transport system (1) that are to be tested during the conformity assessment are derived from physical properties of the real existing controller (21) and from physical properties of the components (2) as indicated in the digital replica dataset or as determined by simulations based on the digital replica dataset.

7. Method according to any of the preceding claims,
wherein properties that are to be tested and cannot be sufficiently derived solely on the basis of information contained in the digital replica dataset are indicated with predefined specification properties in the results log.

8. Method according to claim 7,
wherein the properties that cannot be sufficiently derived solely on the basis of information contained in the digital replica dataset are specifically **characterized in** the results log.

9. Method according to any of the preceding claims,
wherein, in addition to the partially virtualized conformity assessment, a reality-based conformity assessment is also carried out after completion of the passenger transport system (1), in which all of the properties of the passenger transport system (1) that are to be tested during the conformity assessment are determined on the real passenger transport system (1) and additionally indicated as real values in the results log.

10. Method according to claim 9,
wherein the virtual values are also compared with the real values in the results log in order to identify deficits in the design and/or the production of the passenger transport system (1).

11. Method according to any of the preceding claims,
wherein the passenger transport system (1) is selected from a group comprising escalators and moving walkways, and wherein the components (2) of the passenger transport system (1) are selected from a group comprising:
- components of a framework comprising a plurality of components selected from a subgroup comprising upper chords, lower chords, uprights, transverse struts, diagonal struts, gusset plates, support brackets and framework separation points; and
- components of a conveyor apparatus comprising at least one component selected from a subgroup comprising moving stages, moving pallets, conveyor chains, conveyor belts, deflection sprockets, deflection pulleys, drive machines, service brakes and controllers.

12. Method according to any of the preceding claims 1 to 10,
wherein the passenger transport system (1) is an elevator (3) and wherein the components (2) of the passenger transport system (1) are selected from a group comprising:
- components of a support structure (9) comprising a plurality of components (2) selected from a subgroup comprising guide rails (23), wall fastenings (25), support frames (27), floor fastenings (29), transverse struts (31), longitudinal struts (33) and diagonal struts (35); and
- components of a conveyor apparatus (7) comprising at least one component (2) selected from a subgroup comprising elevator cabins (11), counterweights (13), suspension means (15), drive machines (17), braking devices (19) and controllers (21).

13. Device for carrying out an at least partially virtualized conformity assessment on a passenger transport system (1), wherein the device is designed to carry out or control a method according to any of claims 1 to 8.

14. Computer program product, comprising machine-readable program instructions which, when executed on a programmable device, cause the device to carry out or control a method according to any of claims 1 to 8.

15. Computer-readable medium having a computer program product according to claim 14 stored thereon.

## Revendications

1. Procédé pour la réalisation d'une évaluation de conformité au moins partiellement virtualisée sur une installation de transport de personnes (1), dans lequel l'évaluation de conformité est réalisée en suivant un protocole de vérification prédéfini avant la remise de l'installation de transport de personnes (1) à un utilisateur, dans lequel l'installation de transport de personnes (1) a été conçue au préalable de manière individualisée pour une utilisation avec une pluralité de composants (2),
dans lequel un jeu de données de double numérique représentant l'installation de transport de personnes (1) conçue de manière individualisée est créé, dans lequel jeu des propriétés physiques de composants (2) de l'installation de transport de personnes (1) sont reproduites d'une manière pouvant être traitée par une machine,
dans lequel, lors de l'évaluation de conformité, il est vérifié si des propriétés de l'installation de transport de personnes (1) correspondent à des prescriptions de consigne qui définissent au moins un fonctionnement correct des composants (2) et/ou une coopération correcte des composants (2) entre eux et/ou des propriétés de l'installation de transport de personnes (1) relatives à la sécurité,
dans lequel, lors de la réalisation de l'évaluation de conformité, au moins certaines des propriétés de l'installation de transport de personnes (1) à vérifier lors de l'évaluation de conformité, basées sur des propriétés physiques de composants (2), sont déterminées dans le cadre d'étapes d'évaluation de conformité virtualisées par déduction de valeurs à partir du jeu de données de double numérique ou par des simulations basées sur le jeu de données de double numérique et sont indiquées comme valeurs virtuelles dans un protocole de résultats.

2. Procédé selon la revendication 1,
dans lequel, dans le cadre d'une conception de l'installation de transport de personnes (1), des données de consigne de conception sont créées pour des composants à monter dans l'installation de transport de personnes (1), lesquelles données indiquent des propriétés de consigne spécifiques à la conception du composant (2) respectif, et dans lequel, dans le jeu de données de double numérique, les propriétés physiques d'un composant (2) sont indiquées sur la base de ses données de consigne de conception.

3. Procédé selon l'une des revendications précédentes,
dans lequel, dans le cadre d'une fabrication d'un composant (2) à monter dans l'installation de transport de personnes (1), des données réelles de fabrication sont déterminées, qui indiquent des propriétés réelles du composant (2) respectif réalisées lors de la fabrication, et dans lequel, dans le jeu de données de double numérique, les propriétés physiques du composant (2) sont indiquées sur la base de ses données réelles de fabrication.

4. Procédé selon l'une des revendications précédentes,
dans lequel, dans le cadre d'une installation de composants (2) de l'installation de transport de personnes (1) à monter dans l'installation de transport de personnes (1), dans l'installation de transport de personnes (1), des données réelles d'installation sont déterminées, qui indiquent des propriétés réelles réalisées lors de l'installation du composant (2) respectif, et dans lequel, dans le jeu de données de double numérique, les propriétés physiques du composant (2) sont indiquées sur la base de ses données réelles d'installation.

5. Procédé selon l'une des revendications précédentes,
dans lequel toutes les propriétés de l'installation de transport de personnes (1) à vérifier lors de l'évaluation de conformité sont déduites du jeu de données de double numérique ou déterminées par des simulations basées sur le jeu de données de double numérique.

6. Procédé selon l'une des revendications précédentes,
dans lequel l'installation de transport de personnes (1) présente, en tant qu'un de ses composants (2), une commande (21) avec laquelle d'autres composants (2) de l'installation de transport de personnes (1) doivent être commandés,
dans lequel, lors de l'évaluation de conformité, une commande (21) existant réellement communique avec un ordinateur dans lequel les composants (2) à commander sont simulés sur la base de données du jeu de données de double numérique, afin de commander virtuellement les composants (2) simulés,
dans lequel les propriétés de l'installation de transport de personnes (1) à vérifier lors de l'évaluation de conformité sont déduites d'une part des propriétés physiques de la commande (21) existant réellement et d'autre part des propriétés physiques des composants (2), telles qu'elles sont indiquées dans le jeu de données de double numérique ou à déterminer par des simulations basées sur le jeu de données de double numérique.

7. Procédé selon l'une des revendications précédentes,
dans lequel des propriétés à vérifier, qui ne peuvent pas être suffisamment déduites sur la base des seules informations contenues dans le jeu de données de double numérique, sont indiquées avec des propriétés de prescription prédéfinies dans le protocole de résultats.

8. Procédé selon la revendication 7,
dans lequel les propriétés qui ne peuvent pas être suffisamment déduites sur la base des seules informations contenues dans le jeu de données de double numérique sont spécialement caractérisées dans le protocole de résultats.

9. Procédé selon l'une des revendications précédentes,
dans lequel, en plus de l'évaluation de conformité partiellement virtualisée, après l'achèvement de l'installation de transport de personnes (1), une évaluation de conformité basée sur la réalité est réalisé en complément, dans laquelle toutes les propriétés de l'installation de transport de personnes (1) à vérifier lors de l'évaluation de conformité sont déterminées sur l'installation de transport de personnes (1) réelle et sont indiquées en complément comme valeurs réelles dans le protocole de résultats.

10. Procédé selon la revendication 9,
dans lequel les valeurs virtuelles sont comparées en complément aux valeurs réelles dans le protocole de résultats, afin de détecter des déficits dans la conception et/ou la réalisation de l'installation de transport de personnes (1).

11. Procédé selon l'une des revendications précédentes,
dans lequel l'installation de transport de personnes (1) est choisie dans un groupe comprenant des escaliers roulants et des trottoirs roulants et dans lequel les composants (2) de l'installation de transport de personnes (1) sont choisis dans un groupe comprenant :
- des composant d'une charpente comprenant plusieurs composants choisis dans un sous-groupe comprenant des membrures supérieures, des membrures inférieures, des montants, des entretoises transversales, des entretoises diagonales, des goussets, des angles de support et des points de séparation de charpente ; et
- des composants d'un appareil de transport comprenant au moins un composant choisi dans un sous-groupe comprenant des étages roulants, des palettes roulantes, des chaînes de transport, des bandes de transport, des pignons à chaîne de renvoi, des poulies de renvoi, des machines d'entraînement, des freins de service et des commandes.

12. Procédé selon l'une des revendications précédentes 1 à 10,
dans lequel l'installation de transport de personnes (1) est un ascenseur (3) et dans lequel les composants (2) de l'installation de transport de personnes (1) sont choisis dans un groupe comprenant :
- des composants d'une structure de support (9) comprenant plusieurs composants (2) choisis dans un sous-groupe comprenant des rails de guidage (23), des fixations murales (25), des châssis de support (27), des fixations au sol (29), des entretoisements transversaux (31), des entretoisements longitudinaux (33) et des entretoisements diagonaux (35) ; et
- des composants d'un appareil de transport (7) comprenant au moins un composant (2) choisi dans un sous-groupe comprenant des cabines d'ascenseur (11), des contrepoids (13), des moyens de support (15), des machines d'entraînement (17), des dispositifs de freinage (19) et des commandes (21).

13. Dispositif pour la réalisation d'une évaluation de conformité au moins partiellement virtualisée sur une installation de transport de personnes (1), dans lequel le dispositif est configuré pour réaliser ou commander un procédé selon l'une des revendications 1 à 8.

14. Produit programme informatique, comprenant des instructions de programme lisibles par machine, lesquelles, lorsqu'elles sont exécutées sur un dispositif programmable, amènent le dispositif à la réalisation ou la commande d'un procédé selon l'une des revendications 1 à 8.

15. Support lisible par ordinateur sur lequel est stocké un produit programme informatique selon la revendication 14.
